# EUROPÄISCHE PATENTANMELDUNG

(11) **EP 0 865 118 A1**
(43) Veröffentlichungstag der Anmeldung: **16.09.1998**
(21) Anmeldenummer: 97104302.1
(22) Anmeldetag: 13.03.1997
(51) Int. Cl.: H01R 23/70

(54) **Elektrische Baugruppe**

(71) Anmelder: SIEMENS AKTIENGESELLSCHAFT, 80333 München (DE)
(72) Erfinder: Ebert, Wolfgang, 83308 Trostberg (DE)

(57) **Zusammenfassung**

Um eine elektrische Baugruppe mit mindestens einer eine Leiterplatte (2) sowie darauf angeordnete elektrische Bauteile umfassenden Flachbaugruppe in einem metallischen Gehäuse (1) anzuordnen und damit zur Schutzerdung leitend zu verbinden, ist auf der Leiterplatte eine mit einer Masseleiterbahn (21) starr verbundene Drahtbrücke (3) vorgesehen. Quer zur Längsrichtung der Drahtbrücke (3) ausgerichtet ist dieser ein Ausschnitt (23) in der Leiterplatte (2) zugeordnet. Mindestens eine mit dem Gehäuse leitend verbundene Kontaktzunge (11) greift im montierten Zustand der Flachbaugruppe (3) durch den Ausschnitt (23) hindurch und ist an die Drahtbrücke (3) ankontaktiert. Vorzugsweise ist die Kontaktzunge (11) als ein aus dem Gehäusematerial ausgeschnittenes Formteil ausgebildet und besteht aus einem Paar von mit ihren Längsseiten zueinander fluchtend angeordneten Kontaktelementen (11), die schmalseitig untereinander einen an den Durchmesser der Drahtbrücke (3) angepaßten, derart vorbestimmten Abstand (a) aufweisen, daß sie diese im montierten Zustand von beiden Seiten kraftschlüssig umfassen sowie sich schneidend in deren Oberfläche eindrücken.

## Beschreibung

Die Erfindung bezieht sich auf eine elektrische Baugruppe gemäß dem Oberbegriff des Patentanspruches 1.

Betriebsmäßig unter Spannung stehende Teile von elektrischen Geräten, Anlagen oder Betriebsmitteln müssen grundsätzlich so isoliert oder abgedeckt sein, daß sie nicht berührt werden können. Im Fehlerfall könnten aber dennoch leitfähige Teile Spannung gegen Erde annehmen. Daher sind eine Reihe von Schutzmaßnahmen - je nach Anwendungsbereich - allgemeine Vorschrift, um eine Gefährdung dennoch auszuschließen. Dazu gehören unter anderem Schutzisolierung, Schutzerdung bzw. Nullung. Im Falle der Schutzerdung werden leitfähige Anlagenteile über einen Schutzleiter an einen Erder, im letzteren Fall an den Nulleiter des Netzes angeschlossen. Abgesehen von derartigen Schutzerdungen werden in vielen Fällen auch Erdverbindungen bei elektrischen Schaltugnen notwendig, um eine bestimmte Funktion definiert zu erfüllen. Zum Beispiel lassen sich mit einer derartigen funktionalen Erdung hochfrequente Signalanteile ableiten, d.h. HF-Störungen eliminieren.

Voraussetzung für die ordnungsgemäße Funktion der genannten Maßnahmen ist, daß solche leitfähigen Geräte bzw. Anlagenteile elektrisch sicher über einen Schutzleiter mit dem Erder bzw. dem Nulleiter verbunden sind. Bei einer elektrischen Baugruppe mit einer eine Leiterplatte sowie darauf angeordnete elektrische Bauteile umfassenden Flachbaugruppe, die in einem metallischen Gehäuse angeordnet ist, besteht eine der dafür bekannten Möglichkeiten darin, den Erdleiter einerseits mit einer Masseleitungsbahn der Leiterplatte mechanisch sicher zu verbinden. An dem an das Gehäuse anzuschließenden Ende des Erdleiters wird eine Öse angeformt, gegebenenfalls auch als diskretes Element angequetscht und diese mittels einer gegen unbeabsichtigtes Lösen gesicherten Schraubverbindung an dem zu sichernden Gehäuseteil befestigt. Diese an sich sehr sichere Ausgestaltung eines Erdleiterkontaktes hat den Nachteil, daß sie insbesondere bei einer Großserienfertigung von elektrischen Baugruppen relativ aufwendig und umständlich zu handhaben ist. Entweder ist diese Schraubverbindung manuell auszuführen oder es werden dafür aufwendige Bestückungsautomaten benötigt.

In der Handhabung einfacher ist ein Erdleiterkontakt, der als Steckverbindung ausgestaltet ist. Da dafür eine Vielzahl von Lösungen bekannt ist, sei in diesem Zusammenhang nur beispielhaft auf GB-B 14 63 751 hingewiesen. Zwar ist diese Ausführungsform herstellungstechnisch nicht weniger aufwendig, sie wird dennoch bei einer Vielzahl von Anwendungsfällen, insbesondere wegen der Möglichkeit einer werkzeuglosen Handhabung bei Wartungsarbeiten eingesetzt. Im Prinzip besteht diese Steckverbindung gehäuseseitig aus einem Kontaktelement mit einer flachen Kontaktzunge und einem über diese schiebbaren Kabelschuh, der mit dem anzuschließenden Ende des Erdleiters elektrisch gut leitend, beispielsweise über einen Quetschkontakt verbunden ist. Üblicherweise ist diese Kontaktzunge als Teil eines metallischen Winkels ausgebildet, der mittels einer elektrisch leitfähig gestalteten Verbindung an dem zu erdenden Teil der elektrischen Baugruppe festgelegt ist. Wegen ihrer Funktionssicherheit wird diese Lösung trotz des Herstellungsaufwandes in einer Vielzahl von Anwendungsfällen, insbesondere auch wegen ihrer Eigenschaft, sie einfach wieder lösen zu können, eingesetzt.

Die vorstehenden Erläuterungen belegen, daß aus Gründen der elektrischen Sicherheit bei lösbaren Schutzkontakten einiger Aufwand betrieben wird. Zum Herstellen der Schraubverbindung mit dem zu erdenden Gehäuseteil wird in dieses häufig eine Bohrung zum Aufnehmen einer selbstschneidenden Befestigungsschraube eingedrückt, um eine eigene Mutter einzusparen. Dennoch bleibt der Herstellungs- und Montageaufwand hoch. Ließe sich dieser Aufwand in auch nur nennenswertem Umfang reduzieren, so bedeutete dies bei einem Großserienprodukt bereits eine beträchtliche Kostenersparnis.

Der vorliegenden Erfindung liegt daher die Aufgabe zugrunde, bei einer elektrischen Baugruppe der eingangs genannten Art für den Erdkontakt eine weitere Ausführungsform zu schaffen, die ohne Einbuße an elektrischer Sicherheit in der Großserienfertigung einfacher und damit kostengünstiger zu realisieren ist.

Bei einer elektrischen Baugruppe der eingangs genannten Art wird diese Aufgabe erfindungsgemäß durch die im Kennzeichen des Patentanspruches 1 angegebenen Merkmale gelöst.

Dieser erfindungsgemäßen Lösung liegt die kritische Überlegung zugrunde, daß bei der Herstellung einer Flachbaugruppe, für die Bestückung der Leiterplatte mit Bauelementen und deren elektrische Verbindung untereinander eine bestimmte Fertigungstechnologie eingesetzt wird, die Herstellung des Erdkontaktes selbst jedoch weitere, sich davon technologisch unterscheidende und damit kostenintensive Montageschritte bei der konventionellen Realisierung erfordert.

Durch die erfindungsgemäße Lösung wird dieser Technologiebruch im Herstellungsprozeß vermieden. Teil des Erdleiters ist als eine mit der Leiterplatte der Flachbaugruppe mechanisch sicher verbundene Drahtbrücke. Diese ist bei der Montage der Leiterplatte nur eines von mehreren Bauelementen, die die gleichen Montageschritte erfordern. In diesem Falle wird die Drahtbrücke vorzugsweise in zwei Bohrungen der Leiterplatte eingeführt und im Kontakt mit einem Masseleiter der Leiterplatte wie die übrigen elektrischen Bauteile der Flachbaugruppe verlötet. Dieser Drahtbrücke ist ein der zu ihrer Längsrichtung ausgerichteter Ausschnitt in der Leiterplatte, vorzugsweise in Form eines schlitzförmigen Durchbruches, zugeordnet. Beim Aufsetzen der Leiterplatte auf das Gehäuse der elektrischen Baugruppe wird in diesen Ausschnitt eine vom Gehäuse in Richtung der Leiterplatte vorstehende Kontaktzunge eingeführt, die im montierten Zustand durch den Ausschnitt hindurchgreift und in mechanischem Kontakt mit der Drahtbrücke stehend diese elektrisch leitend mit dem Gehäuse der Baugruppe verbindet.

Gemäß einer Weiterbildung der Erfindung ist diese Kontaktzunge derart ausgebildet, daß sie als ein aus dem Gehäusematerial ausgeschnittenes Formteil einstückig mit dem Gehäuse verbunden ist, wobei dann der zugeordnete Ausschnitt in der Leiterplatte - bezogen auf die Schmalseite - eine Breite besitzt, die durch die Dicke des Gehäusematerials vorgegeben ist.

Von besonderem Vorteil ist es, wenn die Kontaktzunge aus einem Paar von mit ihren Längsseiten zueinander fluchtend angeordneten Kontaktelementen besteht, die schmalseitig untereinander einen an den Durchmesser der Drahtbrücke angepaßten, vorbestimmten Abstand aufweisen und die Drahtbrücke im montierten Zustand unter elastischer Vorspannung stehend von beiden Seiten kraftschlüssig umfassen. Bei entsprechend eng toleriertem Abstand der beiden Kontaktelemente werden diese dann beim Montagevorgang durch das Eindrücken der Drahtbrücke zueinander elastisch verspannt, wobei der Federweg sehr gering ist. Aufgrund dieses geringen Federweges sind die federnden Eigenschaften des verwendeten Gehäusematerials von lediglich untergeordneter Bedeutung. Damit ist die Materialauswahl für das metallische Gehäuse und auch für die Kontaktelemente durch diese Funktion keineswegs eingeschränkt. Andererseits folgt aus dieser elastischen Vorspannung der beiden Kontaktelemente, daß sie sich mit ihren Seitenkanten von beiden Seiten her in die Oberfläche der Drahtbrücke eingraben und somit sicherstellen, daß der Übergangswiderstand zwischen ihnen und der Drahtbrücke den für einen Erdkontakt zu fordernden Werten genügt.

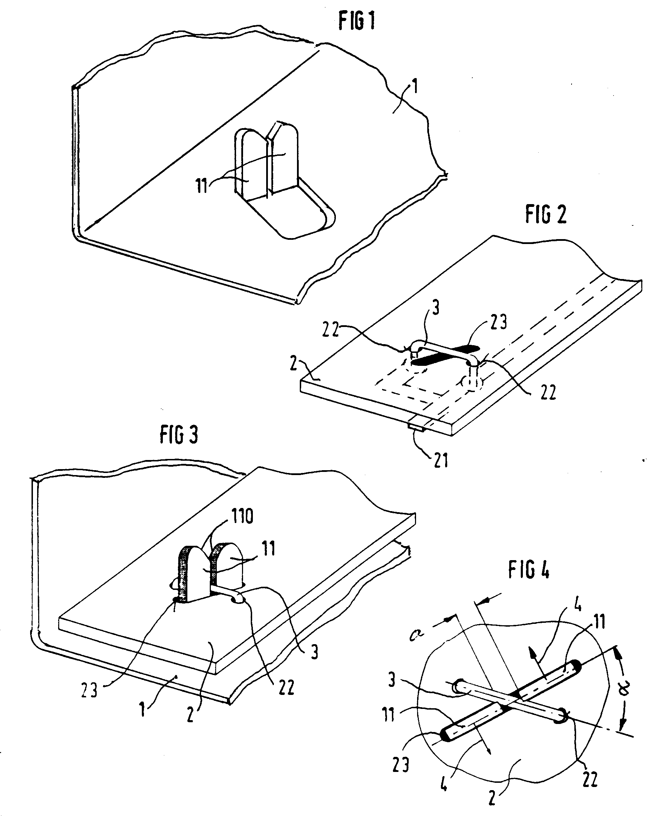

Weitere Vorteile und Ausgestaltungen der erfindungsgemäßen Lösung sind den Erläuterungen zu einem Ausführungsbeispiel der Erfindung zu entnehmen, das im folgenden anhand der Zeichnung näher beschrieben ist. Dabei zeigt Figur 1 schematisch einen Ausschnitt aus einem Gehäuse einer elektrischen Baugruppe mit einem Paar von Kontaktelementen, die aus einem Wandteil des Gehäuses ausgeschnitten sind und einen gehäuseseitigen Anschluß für einen Erdkontakt bilden, Figur 2 schematisch eine Leiterplatte einer in dem Gehäuse anzuordnenden Flachbaugruppe mit einer Drahtbrücke sowie einem dieser Drahtbrücke zugeordneten schlitzförmigen Ausschnitt in der Leiterplatte, wobei die Drahtbrücke das leiterplattenseitige Kontaktelement für den Erdkontakt bildet, Figur 3 schematisch das Gehäuse von Figur 1 und die Leiterplatte von Figur 2 im montierten Zustand und Figur 4 in einem Detailausschnitt der Figur 3 eine Ansicht des Erdkontaktes von oben.

In Figur 1 ist ein metallisches Gehäuse 1 für eine elektrische Baugruppe nur schematisch und in einem Ausschnitt dargestellt, da es allgemein üblich ist, im Betrieb Spannung führende Bauteile einer elektrischen Baugruppe gegen unbeabsichtigte Berührung zu sichern. Deshalb sind auch für derartige Gehäuse vielfache, meist aus Blech durch Abkanten gebildete Ausführungsformen bekannt. Deshalb ist es hier nicht erforderlich, eine solche Ausführungsform eines Gehäuses in allen Einzelheiten zu zeigen und zu beschreiben. Wesentlich ist hier vor allem, ein Paar von zungenförmigen Kontaktelementen 11, das aus dem Boden des Gehäuses 1 zunächst durch Stanzen ausgeschnitten und dann durch Abkanten daraus vertikal vorspringend gebildet ist. Diese Kontaktelemente 11 bilden den gehäuseseitigen Anschluß für einen Erdkontakt.

In Figur 2 ist ebenso schematisch eine Leiterplatte 2 dargestellt, deren Bestückungsseite nach oben weist. Leiterplatten sind als tragendes Bauteil für elektrische bzw. elektronische Flachbaugruppen ebenso allgemein bekannt. Im Prinzip werden in eine solche Leiterplatte 2 von oben her - hier nicht dargestellte - elektrische Bauteile mit ihren drahtförmigen Anschlußkontakten in vorbereitete Durchgangsbohrungen eingesetzt und von der Unterseite her durch Löten mit Leiterbahnen mechanisch verbunden, so daß sich daraus die dem Anwendungsfall angepaßte Schaltungsanordnung mit entsprechenden Leitungsverbindungen ergibt. Dieser prinzipielle Aufbau einer Flachbaugruppe mit einer die elektrischen Bauteile der jeweiligen Schaltungsanordnung tragenden Leiterplatte 2, die ein-aber auch mehrlagig ausgebildet sein kann, ist so allgemein bekannt, daß die Erläuterung von weiteren Einzelheiten hier wohl nicht erforderlich ist.

Statt dessen ist lediglich schematisch eine auf der Unterseite der Leiterplatte 2 angeordnete Masseleiterbahn 21 angedeutet. Diese Masseleiterbahn 21 ist mit einer Drahtbrücke 3 in eben der für den Anschluß von elektrischen Bauteilen beschriebenen Weise verbunden. Die Drahtbrücke 3 ist als U-förmiger Bügel aus einem Abschnitt eines konventionellen Schaltungsdrahtes gebildet, von oben her in ein Paar von entsprechenden Durchgangsbohrungen 22 in der Leiterplatte 2 eingeführt und auf der Unterseite der Leiterplatte 2 über entsprechende Anschlußflecken mit der Masseleiterbahn 21 an entsprechenden Lötpunkten verbunden.

Dieser Drahtbrücke 3 ist nun ein Ausschnitt 23 in Form eines schlitzförmigen, quer zur Längsachse der Drahtbrücke stehenden Durchbruches durch die Leiterplatte 2 zugeordnet. Dieser Ausschnitt 23 nimmt beim Montagevorgang die anhand von Figur 1 beschriebenen zungenförmigen Kontaktelemente 11 des Gehäuses 1 auf.

In Figur 3 ist die Leiterplatte 2 im montierten, d.h. in das Gehäuse 1 eingesetztem Zustand schematisch gezeigt. Diese Darstellung verdeutlicht, daß die beiden Kontaktelemente 11 an den Außenseiten ihrer Stirnflächen abgerundet sind, um sie leichter in den Ausschnitt 23 der Leiterplatte 2 einführen zu können. Weiterhin besitzen die einander zugekehrten Innenseiten dieser Stirnfläche der Kontaktelemente 11 abgeschrägte Anlaufkanten 110, so daß die Drahtbrücke 3 beim Montagevorgang zwischen die beiden Kontaktelemente 11 mit einer entsprechenden Führung hineingleitet.

In Figur 4 ist der in Figur 3 dargestellte montierte Zustand in einer Detailansicht von oben gezeigt. Diese Ansicht verdeutlicht, daß die Verbindungslinie der Durchgangsbohrungen 22 für die Aufnahme der Drahtbrücke 3 unter einem vorgegebenen Winkel α quer zu der Längsrichtung des Ausschnittes 23 in der Leiterplatte steht, der die entsprechend positionierten, gehäuseseitig festgelegten Kontaktelemente 11 aufnimmt. Die Breite der Schmalseite des Ausschnittes 23 ist so toleriert, daß sich die zungenförmigen Kontaktelemente 11 mit ihrer durch die Wandstärke des Gehäusematerials gegebenen Dicke noch bequem einführen lassen. Funktional bedeutsam ist auch die Dimensionierung eines gegenseitigen Abstandes a dieser Kontaktelemente 11. Die wesentlichen Bezugsparameter für die Dimensionierung dieses Abstandes a sind einerseits der Durchmesser der Drahtbrücke 3 und andererseits der genannte Winkel α, d.h. die Ausrichtung der Kontaktelemente 11 in bezug auf die Längsachse der Drahtbrücke 3. Um hohe Funktionssicherheit des Erdkontaktes, also einen möglichst geringen Übergangswiderstand zwischen den Kontaktelementen 11 und der Drahtbrücke zu gewährleisten, ist der Abstand a enger zu tolerieren als die Projektion des Durchmessers der Drahtbrücke 3 auf die Längsrichtung der Kontaktelemente 11.

Unter diesen Voraussetzungen werden die Kontaktelemente 11, die in Richtung ihrer Längsseiten wesentlich steifer sind als in Richtung ihrer Schmalseiten, beim Aufsetzen der Drahtbrücke 3 im wesentlichen quer zur Längsrichtung des Ausschnittes 23 von der Drahtbrücke 3 weggedrückt. Dies ist durch Pfeile 4 in Figur 4 angedeutet. Aufgrund der vorgegebenen Breite der Schmalseite des Ausschnittes 23, der die Kontaktelemente 11 führt, ist der Federweg der Kontaktelemente 11 begrenzt. Daraus folgt, daß sie sich auch bei einem relativ weichen Material lediglich elastisch verspannen und - wie Figur 4 zeigt - mit ihren Schneidkanten in die Oberfläche der Drahtbrücke 3 von beiden Seiten her eingraben. Damit sind eine optimale Kontaktfläche zwischen den Kontaktelementen 11 und der Drahtbrücke 3 sowie aufgrund der elastischen Vorspannung der Kontaktelemente 11 eine hohe Kontaktkraft dauerhaft vorgegeben. Ersichtlich trägt die Querstellung der Längsachsen der Kontaktelemente 11 und der Drahtbrücke 3 zueinander wesentlich zur Funktionssicherheit bei. Es ist deshalb vorteilhaft, den Winkel α deutlich kleiner als 90° zu wählen, vorzugsweise sollte dieser Winkel α in einem Bereich von etwa 30° bis 60° liegen.

Von Vorteil ist es, daß bei dieser Ausgestaltung eines Erdkontaktes für elektrische Baugruppen die Materialeigenschaften sowohl des Gehäuses 1 der Baugruppe - damit der Kontaktelemente 11 - als auch der Drahtbrücke 3 von lediglich untergeordneter Bedeutung für die Funktionssicherheit des Schutzkontaktes sind. Weiterhin läßt sich dieser Schutzkontakt mit Mitteln, auch Werkzeugen und Einrichtungen, die bei der Herstellung und Bestückung von Leiterplatten üblich sind, einfach und sicher realisieren. Der über die Fertigstellung der eigentlichen elektrischen Schaltung hinausgehende Aufwand für diesen Erdkontakt ist gering. Er ist insbesondere dann optimiert, wenn die gehäuseseitigen Kontaktelemente unmittelbar aus einer Gehäusewand ausgeschnitten sind und deshalb kein eigener mit dem Gehäuse verschraubter und die Kontaktelemente tragender Befestigungswinkel eingesetzt wird. Gerade bei hohen Stückzahlen für zu fertigende elektrische Baugruppen ist die beschriebene Ausgestaltung eines Erdkontaktes zwischen Flachbaugruppe und Gehäuse bei hoher Funktionssicherheit eine kostensenkende Lösung.

## Patentansprüche

1. Elektrische Baugruppe mit mindestens einer eine Leiterplatte (2) sowie darauf angeordnete elektrische Bauteile umfassenden Flachbaugruppe, die in einem metallischen Gehäuse (1) angeordnet ist und einen mit dem Gehäuse leitend verbundenen Erdkontakt (11, 3) aufweist**, dadurch gekennzeichnet,** daß auf der Leiterplatte eine mit einer Masseleiterbahn (21) verbundene Drahtbrücke (3) vorgesehen ist, der ein quer zu ihrer Längsrichtung ausgerichteter Ausschnitt (23) in der Leiterplatte zugeordnet ist und daß mindestens eine mit dem Gehäuse verbundene Kontaktzunge (11) vorgesehen ist, die im montierten Zustand durch den Ausschnitt hindurchgreifend an die Drahtbrücke ankontaktiert ist.

2. Elektrische Baugruppe nach Anspruch 1, **dadurch gekennzeichnet,** daß die Drahtbrücke (3) auf der Bauelementeseite der Leiterplatte (2) angeordnet und ebenso wie andere elektrische Bauteile der Flachbaugruppe in die Leiterplatte (2) eingelötet ist.

3. Elektrische Baugruppe nach Anspruch 1 oder 2, **dadurch gekennzeichnet,** daß die Kontaktzunge (11), ausgebildet als ein aus dem Gehäusematerial ausgeschnittenes Formteil, einstückig mit dem Gehäuse (1) verbunden ist und der Ausschnitt (23) in der Leiterplatte (2) bei schlitzförmigem Querschnitt an der Schmalseite eine Breite aufweist, die an die Dicke des Gehäusematerials angepaßt ist.

4. Elektrische Baugruppe nach einem der Ansprüche 1 bis 3, **dadurch gekennzeichnet,** daß die Kontaktzunge aus einem Paar von mit ihren Längsseiten zueinander fluchtend angeordneten Kontaktelementen (11) besteht, die schmalseitig untereinander einen an den Durchmesser der Drahtbrücke (3) angepaßten, vorbestimmten Abstand (a) aufweisen und im montierten Zustand die Drahtbrücke von beiden Seiten unter elastischer Vorspannung stehend kraftschlüssig umfassen.

5. Elektrische Baugruppe nach Anspruch 4**, dadurch gekennzeichnet,** daß der gegenseitige Abstand (a) der Kontaktelemente (11) derart eng toleriert ist, daß sich diese beim Montagevorgang von beiden Seiten schneidend in die Oberfläche der Drahtbrücke (3) eindrücken.

6. Elektrische Baugruppe nach einem der Ansprüche 1 bis 5, **dadurch gekennzeichnet, daß** die quer zueinander stehenden Längsachsen des Ausschnitts (23) in der Leiterplatte (2) und der diesem Ausschnitt zugeordneten Drahtbrücke (3) unter einem Winkel (α) zueinander stehen, der kleiner als 90° ist.

7. Elektrische Baugruppe nach Anspruch 6, **dadurch gekennzeichnet,** daß der Winkel (α), den die Längsachsen des Ausschnitts (23) in der Leiterplatte (2) und der diesem Ausschnitt zugeordneten Drahtbrücke (3) miteinander bilden, in einem Bereich von 30° bis 60° liegt.

8. Elektrische Baugruppe nach einem der Ansprüche 4 bis 7, **dadurch gekennzeichnet,** daß die beim Montagevorgang durch den Ausschnitt (23) in der Leiterplatte (2) hindurchgeführten Stirnflächen der Kontaktelemente (11) jeweils einander zugekehrte Anlaufkanten (110) für die dazwischen einzuführende Drahtbrücke (3) aufweisen.
